# EUROPEAN PATENT APPLICATION

(11) **EP 2 378 542 A1**
(43) Date of publication of application: **19.10.2011**
(21) Application number: 09831918.9
(22) Date of filing: 09.12.2009
(51) Int. Cl.: H01L 21/02, G01V 8/12, H01L 21/306, H01L 21/66

(54) **SUBSTRATE AND METHOD FOR MANUFACTURING SUBSTRATE**

(30) Priority: 11.12.2008 JP 2008315919
(71) Applicant: Sumitomo Electric Industries, Ltd., Chuo-ku Osaka-shi Osaka 541-0041 (JP)
(72) Inventor: MASUDA, Takeyoshi, Osaka-shi Osaka 554-0024 (JP)
(74) Representative: Grünecker, Kinkeldey, Stockmair & Schwanhäusser
(86) International application number: PCT/JP2009/070587
(87) International publication number: WO 2010/067814

(57) **Abstract**

A substrate, the presence of which can be detected with a method similar to a conventional method of detecting a Si substrate even if the substrate is transparent, and a method of manufacturing the substrate are provided. Light (10) incident on an end portion of a transparent substrate (1) is not transmitted through the substrate (1) as with the light (10) incident on a central portion of the substrate (1), but is totally reflected from a total reflection surface (2) in a detection region present in at least a portion of the end portion of the substrate (1). A photoelectric sensor (30) can recognize that a ratio of transmission of the light (10) at the end portion of the substrate (1) has become smaller, thereby detecting the presence of the substrate (1).

## Description

### TECHNICAL FIELD

The present invention relates to a substrate and a method of manufacturing a substrate, and more particularly to a substrate, the presence of which can be recognized by a sensor even if the substrate is transparent, and a method of manufacturing the substrate.

### BACKGROUND ART

When a semiconductor element such as a MOSFET (Metal Oxide Semiconductor Field Effect Transistor) is formed on a main surface of a semiconductor substrate, the semiconductor element is usually formed in a region of a central portion on the main surface at a certain distance (usually approximately 5 mm) or more from a periphery of the semiconductor substrate. The main surface as used herein refers to a surface of the largest area among surfaces. Thus, the semiconductor element is not formed in a region within the certain distance from the periphery of the semiconductor substrate. This is because a semiconductor element formed close to the periphery of the main surface, i.e., in a region at an end portion, may have lower reliability in electric characteristics and the like.

In the region close to the periphery of the main surface of the semiconductor substrate described above where a semiconductor element is not formed, i.e. in the end portion, an ID mark is often formed, for example. The ID mark is used for integrated production control during steps of manufacturing a semiconductor device having numerous semiconductor elements formed on a main surface of a semiconductor substrate. Namely, a number, a character, a bar code or the like for identifying each semiconductor substrate may be arranged as an ID mark at an end portion of a main surface of a semiconductor substrate.

A conventionally used ID mark is numerous dots (recesses) formed at an end portion of a main surface of a semiconductor substrate, for example. This is formed by irradiating a main surface of a semiconductor substrate with a laser beam to partially remove a material forming the semiconductor substrate, for example, thus arranging a group of dots for identifying the semiconductor substrate in a region at an end portion of the main surface of the semiconductor substrate. For example, Japanese Patent Laying-Open No. 2004-200635 (hereinafter referred to as "Patent Document 1") discloses a semiconductor wafer having a recess which does not contact a polishing cloth for performing a CMP step, and dots formed on a bottom surface of the recess, in order to prevent the formed dots from being polished and planarized in a subsequent chemical mechanical polishing step (CMP step), which results in difficulty in recognizing the presence of the dots by a sensor.

### PRIOR ART DOCUMENTS

### PATENT DOCUMENTS

Patent Document 1: Japanese Patent Laying-Open No. 2004-200635

### SUMMARY OF THE INVENTION

### PROBLEMS TO BE SOLVED BY THE INVENTION

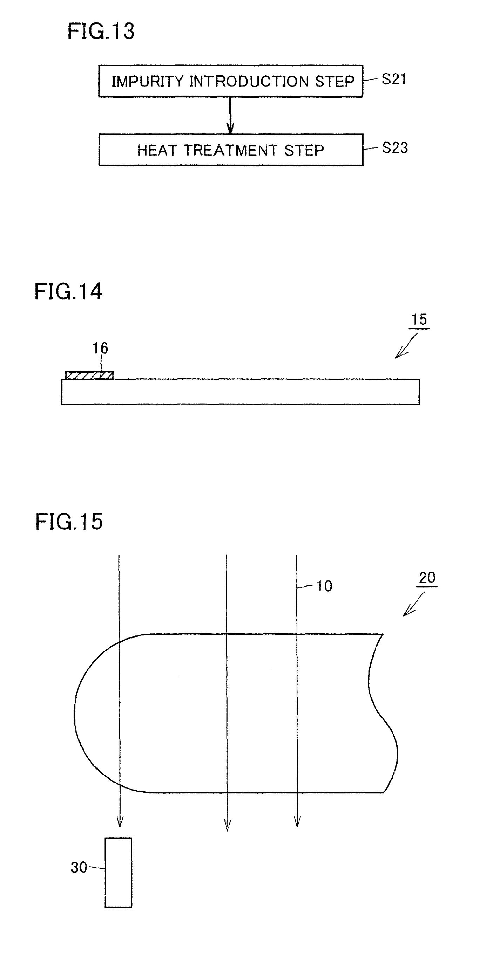

As disclosed in Patent Document 1, for example, a bevel cut has commonly been used for a shape of an end portion of a main surface of a substrate, in which the end portion is processed to become an end surface having a certain inclined angle with respect to the main surface in order to suppress chipping. Specifically, a surface forming a prescribed angle with one main surface of a substrate and the other main surface of the substrate opposite to the one main surface is formed at an end portion of the substrate to intersect with both of the main surfaces, as an end surface of the substrate. Other than the bevel cut, an end portion of main surfaces of a substrate may be processed to become a plane end surface or a spherical end surface, for example, in order to suppress occurrence of cleavage (crack) and chipping in a direction along a crystal lattice from the end portion of a semiconductor substrate or a glass substrate due to application of stress, for example. By way of example, Fig. 15 is a schematic diagram showing a rounded end portion of a substrate. In a substrate 20 shown in Fig. 15, the end portion of main surfaces has been specially processed into a curved shape called a round. Namely, a curved surface (end portion depicted as a left semicircular portion in Fig. 15) connecting one main surface (upper surface in Fig. 15) of substrate 20 with the other main surface (lower surface in Fig. 15) opposite to the one main surface is provided as the end surface of the substrate.

During production of a semiconductor device, a method of managing a semiconductor substrate and executing an automatic sequence by recognizing the presence of the semiconductor substrate by a sensor, simultaneously recognizing an ID mark of the semiconductor substrate, and checking the mark is generally employed in the course of handling and transfer of the semiconductor substrate in a manufacturing device used for the production. Here, in the step of recognizing the presence of the semiconductor substrate, a red or infrared LED (light emitting diode) or an LD (laser diode) is generally used as a light source. This is because silicon (Si) commonly used for a conventional semiconductor substrate absorbs red light or infrared light, so that a semiconductor substrate made of silicon can be readily detected with these lights.

As shown in Fig. 15, for example, red light or infrared light is emitted from a region facing the one main surface of substrate 20 (semiconductor substrate made of Si, for example) to the one main surface (upper surface in Fig. 15). In a region facing the main surface (lower surface in Fig. 15) opposite to the one main surface of substrate 20, a photoelectric sensor 30 for recognizing light 10 such as incident red light is provided. When substrate 20 is not present, light 10 emitted from above the one main surface of substrate 20 as shown in Fig. 15 is incident on photoelectric sensor 30. When photoelectric sensor 30 detects light 10, it can be recognized that substrate 20 is not present. If substrate 20 made of a material which absorbs red light or infrared light such as Si is present, however, light 10 emitted from above in Fig. 15 is mostly absorbed or reflected by the main surface of substrate 20. Consequently, an amount of light 10 reaching photoelectric sensor 30 present below in Fig. 15 becomes smaller than when substrate 20 is not present. In short, when intensity of light 10 received by photoelectric sensor 30 present below substrate 20 in Fig. 15 becomes lower than when substrate 20 is not present, the presence of substrate 20 can be detected by photoelectric sensor 30.

In recent years, a semiconductor element (semiconductor device) including a compound semiconductor such as silicon carbide (SiC) instead of Si has been receiving attention as a material for realizing a high-frequency power device, and a heat-resistant or radiation-resistant device. This is because a compound semiconductor such as SiC or GaN has a larger band gap and higher breakdown electric field strength than those of Si, so that a semiconductor device including such compound semiconductor has better switching characteristics and a higher withstand voltage than those of a semiconductor device including Si, for example. However, since a substrate including SiC, GaN or the like among substrates including such compound semiconductors is transparent, light emitted to the substrate is hardly reflected from the substrate, but is mostly transmitted through the substrate. Accordingly, when light 10 such as red light or infrared light is emitted to substrate 20 as shown in Fig. 15, if substrate 20 in Fig. 15 is a transparent substrate as described above, a ratio of light 10 reflected off substrate 20 becomes lower (i.e., a ratio of light 10 transmitted through substrate 20 becomes higher) than when light 10 is emitted to a substrate made of Si, for example. It is thus difficult for photoelectric sensor 30 to recognize the presence of substrate 20 based on variation in intensity of light 10.

In a manufacturing process for a semiconductor device including a transparent substrate made of the above compound semiconductor or the like, which is partly similar to a manufacturing process for a conventional semiconductor device including a Si substrate, a manufacturing device used for manufacturing the conventional semiconductor device including a Si substrate may used. With the conventional method of detecting the presence of a Si substrate, however, it is difficult to accurately detect the presence of a transparent substrate, as described above. As such, it has been difficult to use the manufacturing device used for producing the conventional semiconductor device including a Si substrate also for manufacturing the above semiconductor device including a transparent substrate. Employing a detection method for detecting the presence of a transparent substrate different from the conventional method requires a major modification of the manufacturing device, resulting in increased cost of the manufacturing device and the like.

The present invention was made in view of the problems described above, and an object of the present invention is to provide a substrate, the presence of which can be detected with a method similar to a conventional method of detecting a Si substrate even if the substrate is transparent, and a method of manufacturing the substrate.

### MEANS FOR SOLVING THE PROBLEMS

A substrate according to the present invention is a transparent substrate, which includes a detection region formed in at least a portion of an end portion of the substrate and having a transmittance of light lower than a transmittance of the light in a central portion of the substrate.

The transparent substrate as used herein refers to a substrate having a low absorptance (high transmittance) of light having a prescribed wavelength (e.g., visible light (red light) or infrared light), the absorptance of light having a prescribed wavelength being more than 0% and not more than 90%, for example. From another perspective, a substrate transparent to visible light, for example, refers to a substrate through which a region facing one main surface of the substrate can be seen visually from a region facing the other main surface opposite to the one main surface of the substrate. A partial region (end portion in this case) of the main surfaces of the substrate is defined as a detection region, and a ratio of light transmitted from the region facing the one main surface of the substrate to the region facing the other main surface opposite to the one main surface (transmittance) in the detection region is made lower than a transmittance of the light in a region (central portion in this case) other than the detection region of the main surfaces of the substrate. Consequently, a sensor for sensing transmission of light (e.g., photoelectric sensor) can recognize that light incident on the main surface of the substrate is cut off (not transmitted) to a greater degree in the detection region than in the region other than the detection region. The sensor can therefore recognize (detect) the presence of the transparent substrate. Accordingly, a conventional device of detecting a Si substrate can also be used for detecting the above substrate. Therefore, a manufacturing device used in steps of manufacturing the conventional semiconductor device including a Si substrate may also be used in steps of manufacturing the semiconductor device including a transparent substrate described above. Since a semiconductor element or the like is not usually formed at an end portion of a substrate as described above, it is not likely that the number of elements formed on the substrate decreases (manufacturing efficiency of elements is reduced) even if the detection region as described above is formed at the end portion of the substrate.

In the substrate according to the present invention, the detection region preferably includes a total reflection surface for totally reflecting the light incident on the detection region. By totally reflecting the light incident on the detection region, substantially all of the light incident on the detection region is reflected off a surface of the detection region on which the light was incident. Consequently, the light incident on the detection region hardly enters the substrate from the detection region to be transmitted from a rear surface (main surface opposite to the side on which the light was incident) of the substrate to the outside of the substrate. Since the light traveling in a direction intersecting with the main surfaces of the substrate is cut off in the substrate as described above, the sensor for sensing transmission of light can recognize (detect) the presence of the substrate.

In the substrate according to the present invention, the detection region may include a diffuse reflection surface for diffusely reflecting the light incident on the detection region. By diffusely reflecting the light incident on the detection region, the light incident on the detection region is mostly reflected off a surface of the detection region on which the light was incident. Consequently, the light incident on the detection region is mostly reflected owing to the presence of the substrate as in the case where the above total reflection surface is provided, so that the photoelectric sensor can recognize (detect) the presence of the substrate.

The substrate according to the present invention preferably includes at least one selected from the group consisting of SiC, GaN (gallium nitride), sapphire, AlN (aluminum nitride), and diamond. A substrate including such material(s) is a transparent substrate. Accordingly, by providing the detection region having the lowered light transmittance as described above when forming a semiconductor device with such substrate, the presence of the substrate can be readily detected by the sensor.

Next, a method of manufacturing a substrate according to the present invention includes the steps of preparing a transparent substrate, and performing a process of making a transmittance of light in at least a portion of an end portion of the substrate lower than a transmittance of the light in a central portion of the substrate. As described above, in a transparent substrate, light such as visible light (e.g., red light) or infrared light incident on one main surface of the substrate usually mostly passes through the substrate and is emitted from a main surface (rear surface) opposite to the one main surface. It is thus difficult to detect the presence of a transparent substrate by a sensor such as a photoelectric sensor. In order to avoid such difficulty, the step of forming a transparent substrate includes the step of forming a region (detection region) having a lowered transmittance of incident light in a portion of the substrate, as described above. Making the transmittance of incident light lower in the portion of the substrate specifically means performing a process of setting the light transmittance in this region of the substrate to not more than 10% of the light transmittance in a region other than this region of the substrate (i.e., a region where its transmittance has not been made lower).

In the substrate thus formed, the transmittance of light incident on the partial region (detection region) becomes relatively low even if the substrate is transparent. Accordingly, the sensor can recognize through the detection region that an amount light passing through the substrate and being transmitted to the outside of the substrate has become smaller. Therefore, the sensor can detect the presence of the transparent substrate.

In the method of manufacturing a substrate according to the present invention, the step of performing the process preferably includes the step of forming a total reflection surface for totally reflecting the light incident on at least a portion of the end portion. By forming the total reflection surface and totally reflecting the incident light in the detection region described above, the light incident on the detection region is not transmitted through the substrate. Accordingly, the sensor can detect the presence of the substrate based on variation in light transmittance in the detection region. With the method of manufacturing a substrate including the step of forming the total reflection surface as described above, a transparent substrate, the presence of which can be readily detected by the sensor (by detecting variation in light transmittance), can be formed.

The step of forming the total reflection surface preferably includes the step of machine-processing at least a portion of the end portion. Alternatively, the step of forming the total reflection surface described above may include the step of laser-processing at least a portion of the end portion. With these processing methods, any region on the surface of the substrate can be readily processed into any shape (to become the total reflection surface described above). With these processing methods, therefore, the total reflection surface can be readily formed, so that the detection region can be readily formed where a ratio of light incident on the one main surface of the substrate being transmitted to the outside of the substrate (transmittance) is made lower.

In the method of manufacturing a substrate according to the present invention, the step of performing the process may include the step of forming a diffuse reflection surface for diffusely reflecting light incident on at least a portion of the end portion. As with the total reflection surface, the diffuse reflection surface of the substrate reflects light incident on the portion (detection region) at the end portion of the substrate, thus preventing the light from passing through the substrate and being transmitted to the rear surface side. Accordingly, as in the case where the total reflection surface is formed, the presence of the substrate can be readily detected by the sensor also when the diffuse reflection surface is formed.

The step of forming the diffuse reflection surface preferably includes the step of machine-processing at least a portion of the end portion, as with the step of forming the total reflection surface. Alternatively, the step of forming the diffuse reflection surface may include the step of laser-processing at least a portion of the end portion. With these processing methods, any region on the surface of the substrate can be readily processed into any shape to become the diffuse reflection surface. With these processing methods, therefore, the diffuse reflection surface can be readily formed. Accordingly, the detection region can be readily formed where the transmittance of light incident on the main surface of the substrate is made lower.

In the method of manufacturing a substrate according to the present invention, the step of forming the diffuse reflection surface may include the step of introducing an impurity into at least a portion of the end portion, and the step of increasing surface roughness of a surface of a region where the impurity was introduced. For example, the step of increasing the surface roughness of the surface may include the step of etching a surface layer of the region where the impurity was introduced, or the step of subjecting the surface layer of the region where the impurity was introduced to heat treatment. By performing etching or heat treatment, projections and recesses can be formed in the surface of the region where the impurity was introduced, thus increasing the surface roughness. With the increased surface roughness of the region, the region can act as the diffuse reflection surface. With the processing method described above, therefore, the diffuse reflection surface to act as the detection region can be readily formed. Accordingly, the detection region can be readily formed where the transmittance of light incident on the main surface of the substrate is made lower.

Further, in the method of manufacturing a substrate according to the present invention, the step of forming the diffuse reflection surface preferably includes the step of depositing a thin film on at least a portion of the end portion. That is, instead of increasing the surface roughness of a prescribed region on the main surface of the substrate to make the region as the diffuse reflection surface as described above, a thin film that can be used as the diffuse reflection surface may be formed on the main surface of the substrate. A diffuse reflection surface formed from the thin film thus formed can produce the same effect as that of the diffuse reflection surface formed by increasing the surface roughness. Further, in the method of manufacturing a substrate according to the present invention, the step of forming the total reflection surface may include the step of depositing a thin film on at least a portion of the end portion. Any thin film having a surface to act as the total reflection surface can be used as the thin film. Again in this case, the same effect can be produced as in the case where the total reflection surface is formed by machine processing or the like.

### EFFECTS OF THE INVENTION

According to the present invention, a substrate, the presence of which can be recognized by a sensor even if the substrate is transparent, and a method of manufacturing the substrate can be provided.

### BRIEF DESCRIPTION OF THE DRAWINGS

Fig. 1 is a schematic cross-sectional view showing an example of a substrate according to a first embodiment of the present invention.
Fig. 2 is a schematic cross-sectional view showing an example of a total reflection surface of the substrate according to the first embodiment of the present invention.
Fig. 3 is a flowchart illustrating a method of manufacturing the substrate according to the first embodiment of the present invention.
Fig. 4 is a cross-sectional view showing a modification of the example of the substrate in a detection region, according to the first embodiment of the present invention.
Fig. 5 is a cross-sectional view showing another modification of the example of the substrate in the detection region, according to the first embodiment of the present invention.
Fig. 6 is a schematic cross-sectional view showing an example of a substrate according to a second embodiment of the present invention.
Fig. 7 is a schematic cross-sectional view showing an example of a diffuse reflection surface of the substrate according to the second embodiment of the present invention.
Fig. 8 is a cross-sectional view showing a modification of the example of the substrate in a detection region, according to the second embodiment of the present invention.
Fig. 9 is a cross-sectional view showing another modification of the example of the substrate in the detection region, according to the second embodiment of the present invention.
Fig. 10 is a flowchart illustrating another method of forming the diffuse reflection surface according to the second embodiment of the present invention.
Fig. 11 is a schematic cross-sectional view showing an example of an impurity introduction step (S21) in the flowchart shown in Fig. 10.
Fig. 12 is a schematic cross-sectional view showing an example of an etching step (S22) in the flowchart shown in Fig. 10.
Fig. 13 is a flowchart illustrating a method of forming the diffuse reflection surface according to the second embodiment of the present invention with a thermal diffusion method.
Fig. 14 is a schematic cross-sectional view showing an example of a substrate according to a third embodiment of the present invention.
Fig. 15 is a schematic diagram showing a rounded end portion of a substrate.

### MODES FOR CARRYING OUT THE INVENTION

Hereinafter, embodiments of the present invention will be described with reference to the drawings. It is noted that parts performing the same function have the same reference characters allotted in each embodiment, and description thereof will not be repeated unless otherwise necessary.

### (First Embodiment)

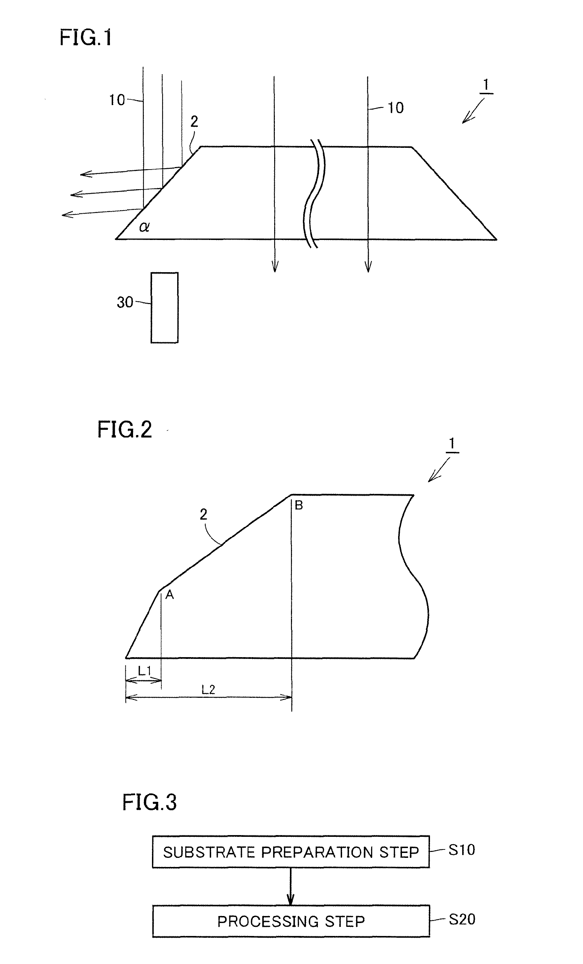

Referring to Fig. 1, a substrate 1 according to a first embodiment of the present invention is a transparent substrate having a prescribed thickness (vertical direction in Fig. 1), which is used for a semiconductor device such as a high-frequency power device or a heat-resistant or radiation-resistant device. Although substrate 1 is depicted as a trapezoid in Fig. 1 for the sake of convenience, it is actually a plate having a thickness (vertical direction in Fig. 1) of approximately 1 mm, for example, and a diameter (horizontal direction in Fig. 1) of approximately 2 inches, for example. Thus, double wavy lines are used in Fig. 1 to indicate omission of width in the horizontal direction.

Substrate 1 in Fig. 1 is a transparent substrate as described above, and specifically, preferably made of a material including at least one selected from the group consisting of SiC, GaN, sapphire, AlN, and diamond, for example. Substrate 1 made of such material(s) may be utilized as a substrate of a semiconductor element (semiconductor device) such as a power device including a compound semiconductor.

Since substrate 1 in Fig. 1 is transparent, light 10 transmitted from an upper main surface side of substrate 1 to a lower main surface (rear surface) side in a direction intersecting with (substantially perpendicular to) the main surfaces passes through substrate 1 at a high ratio in a central portion in Fig. 1 (central portion in the horizontal direction in Fig. 1), and is emitted from the lower main surface to the outside of substrate 1. Light 10 may be visible light such as red light, or non-visible light such as infrared light. Particularly, when substrate 1 made of the above material(s) is used, substrate 1 is preferably transparent to light having a wavelength of not less than 200 nm and not more than 800 nm. It is particularly preferable that substrate 1 is transparent to light having a wavelength of not less than 300 nm and not more than 700 nm. With light having such wavelength as light 10, a sensor having high accuracy can be operated.

In contrast, light 10 incident on an end portion of substrate 1 (right and left sides of substrate 1 in Fig. 1) is not transmitted through substrate 1 as with light 10 incident on the central portion of substrate 1, even if having the same wavelength and the same intensity as light 10 incident on the central portion of substrate 1, but is totally reflected from a total reflection surface 2 in a detection region present in at least a portion of the end portion of substrate 1 as shown in Fig. 1. The detection region as used herein refers to a region having a transmittance of light 10 lower than a transmittance of light 10 in the central portion of substrate 1. In substrate 1 shown in Fig. 1, the entire region where total reflection surface 2 is formed in the horizontal direction in Fig. 1 (peripheral end portions of substrate 2) is referred to as the detection region. Specifically, not only total reflection surface 2 but also a peripheral end portion on the rear surface side of substrate 1 facing a photoelectric sensor 30 in Fig. 1 is included in the detection region, for example.

In substrate 1 shown in Fig. 1, the detection region is formed as including total reflection surface 2 having a prescribed angle with respect to the main surfaces of substrate 1. That is, total reflection surface 2 performs the function of making a ratio at which light 10 emitted to the detection region is transmitted through substrate 1 (transmittance) lower than a ratio at which light 10 in a region other than the detection region is transmitted through substrate 1, by totally reflecting light 10 in the detection region. Accordingly, total reflection surface 2 is an inclined surface having a prescribed angle α with respect to the main surfaces (horizontal direction in Fig. 1) of substrate 1, the angle being such that when light 10 is emitted to substrate 1 in the direction intersecting with (perpendicular to) the main surfaces of substrate 1 as shown in Fig. 1, for example, light 10 incident on total reflection surface 2 can be totally reflected off total reflection surface 2. In addition, a surface of total reflection surface 2 preferably has its surface roughness lowered to a degree that can cause total reflection of light 10 incident on total reflection surface 2 without causing diffuse reflection. By doing so, light 10 incident on total reflection surface 2 is totally reflected, as shown in Fig. 1.

Since light 10 incident on total reflection surface 2 is reflected off total reflection surface 2, light 10 hardly reaches photoelectric sensor 30 for recognizing (detecting) incident light 10, which is arranged in a position overlapping total reflection surface 2 in the detection region when viewed two-dimensionally (i.e., immediately below total reflection surface 2), as shown in Fig. 1. As such, photoelectric sensor 30 can recognize that light 10 has been cut off owing to the presence of substrate 1 arranged above photoelectric sensor 30. Consequently, the presence of substrate 1 can be detected based on variation in amount of light detected by photoelectric sensor 30. By including total reflection surface 2 in this manner, photoelectric sensor 30 can recognize (detect) the presence of substrate 1 even if substrate 1 is made of a material through which light 10 is transmitted.

Fig. 2 is a cross-sectional view showing enlarged total reflection surface 2 on the left side of substrate 1 in Fig. 1. Thus, a wavy line is used on the right side in Fig. 2 to indicate omission of the right region of substrate 1 in Fig. 1.

Total reflection surface 2 of substrate 1 shown in Fig. 2 forms angle α with the main surfaces (surfaces extending in the horizontal direction in Fig. 1) of substrate 1, as shown in Fig. 1. As described above, angle α can cause light 10 incident on substrate 1 in the direction perpendicular to the main surfaces of substrate 1 to be totally reflected off total reflection surface 2, for example.

The detection region in which total reflection surface 2 is arranged is preferably formed in a region within a distance (distance from a left end toward the right in Fig. 2) of not less than 0.1 mm and not more than 5 mm from a peripheral end (left end in Fig. 2) of substrate 1 in the main surface direction, as shown in Fig. 2. That is, if total reflection surface 2 is formed from a point A to a point B in Fig. 2, a distance L1 from the peripheral end of substrate 1 to point A in the main surface direction is preferably not less than 0.1 mm, and a distance L2 from the peripheral end of substrate 1 to point B in the main surface direction is preferably not more than 5 mm. If total reflection surface 2 is arranged to intersect with the lower main surface in Fig. 2, which includes a case where total reflection surface 2 is arranged in a region of less than 0.1 mm from an end surface of substrate 1, an angle formed between total reflection surface 2 and the lower main surface in Fig. 2 may become smaller (acute). In this case, chipping and cleavage may occur in substrate 1 from the peripheral end (end portion of substrate 1 forming the acute angle). In order to suppress the occurrence, as shown in Fig. 2, it is preferable for a region having distance L 1 of less than 0.1 mm from the peripheral end in the main surface direction to be provided with an end surface having a larger angle with respect to the main surfaces than an angle formed between total reflection surface 2 and the main surfaces, for example. The end surface from the peripheral end to point A may have a plane shape as shown in Fig. 2, or a curved shape. Depending on a value of angle α, the end surface from the peripheral end to point A shown in Fig. 2 as described above may not be provided (total reflection surface 2 may be formed entirely toward the periphery from point B).

A region of not less than 5 mm from the peripheral end of substrate 1 corresponds to the central portion of the main surface of substrate 1, where a semiconductor element and the like are to be formed. Accordingly, if total reflection surface 2 is provided in the region of not less than 5 mm from the end surface of substrate 1, the region where a semiconductor element and the like are to be formed on the main surface of substrate 1 becomes smaller, resulting in lower productivity of semiconductor elements. It is thus preferable to set distance L2 to not more than 5 mm.

Total reflection surface 2 should only be formed in at least a portion of the end portion of the main surface of substrate 1. That is, total reflection surface 2 may be formed entirely in the region within a distance of not less than 0.1 mm and not more than 5 mm from the end surface of the main surface of substrate 1, all the way around the peripheral portion of the main surface of substrate 1, or may be formed only in a portion in a circumferential direction of the peripheral portion.

Next, a method of manufacturing the substrate according to the first embodiment of the present invention is described. As shown in Fig. 3, when substrate I according to the first embodiment of the present invention is formed, first, a substrate preparation step (S10) is performed. Specifically, this is a step of preparing a transparent substrate to be used as transparent substrate 1 (see Fig. 1), the presence of which can be recognized with light 10 (see Fig. 1) emitted for detecting the substrate in a manufacturing device for a semiconductor device (e.g., deposition device or etching device).

The substrate prepared in this step is a semiconductor substrate which will have a semiconductor element and the like formed on one main surface thereof to form a semiconductor device such as a power device, and is preferably a transparent semiconductor substrate through which at least 10% of light 10 such as visible light (red light) or infrared light is transmitted. Specifically, the substrate is made of a material including at least one selected from the group consisting of SiC, GaN, sapphire, AlN, and diamond, for example.

In this substrate preparation step (S 10), the above-described substrate having the prescribed thickness and the main surface of the prescribed size may be prepared by externally purchasing the substrate or the like. Alternatively, the substrate may be prepared by making an ingot including crystals forming the semiconductor substrate with the Czochralski method, a boat method, a solution growth method or the like, and by slicing the ingot into substrates in a shape having the prescribed thickness and the main surface of the prescribed size by means of a wire saw, for example.

After the transparent substrate to be used as a substrate of a semiconductor device is prepared as described above, a processing step (S20) is performed. Specifically, this is a step of performing a process of making a light transmittance in a region in at least a portion of the end portion of the substrate prepared in the substrate preparation step (S 10) lower than a light transmittance in a central portion of the main surface of the substrate, in order for the light transmittance in the region to function as the detection region. Making the light transmittance lower specifically means performing a process of making the light transmittance in that region of the substrate lower than the light transmittance in a region other than that region of the substrate (i.e., a region where its transmittance has not been made lower). Preferably, it means performing a process of setting the light transmittance in that region to not more than 10% of the light transmittance in a region other than that region. By doing so, even if the substrate is transparent, photoelectric sensor 30 (see Fig. 1) can recognize that transmission of light has been cut off during processing of the substrate in a manufacturing device, for example, thereby detecting the presence of the substrate.

In this processing step (S20), in order to make the light transmittance in the region in at least a portion of the end portion of the main surface of the substrate lower than the light transmittance in the central portion of the main surface of the substrate, a step of forming a total reflection surface for totally reflecting light incident on at least a portion of the end portion of the substrate is performed. As a result, total reflection surface 2 shown in Fig. 1 is formed, which has prescribed angle α satisfying a condition that can cause total reflection when light 10 traveling in a direction intersecting with, e.g., perpendicular to, the main surfaces (horizontal direction in Fig. 1) of substrate 1 is emitted. As shown in Fig. 1, light 10 emitted to the region other than total reflection surface 2 on the surface of substrate 1 is mostly transmitted through substrate 1 because substrate 1 is transparent, whereas light 10 emitted to total reflection surface 2 in the detection region is totally reflected. Accordingly, light 10 hardly reaches photoelectric sensor 30 arranged in a position overlapping total reflection surface 2 of substrate 1 when viewed two-dimensionally (i.e., immediately below total reflection surface 2), as shown in Fig. 1. Therefore, photoelectric sensor 30 can recognize that light 10 has been cut off owing to the presence of substrate 1, thereby detecting the presence of substrate 1.

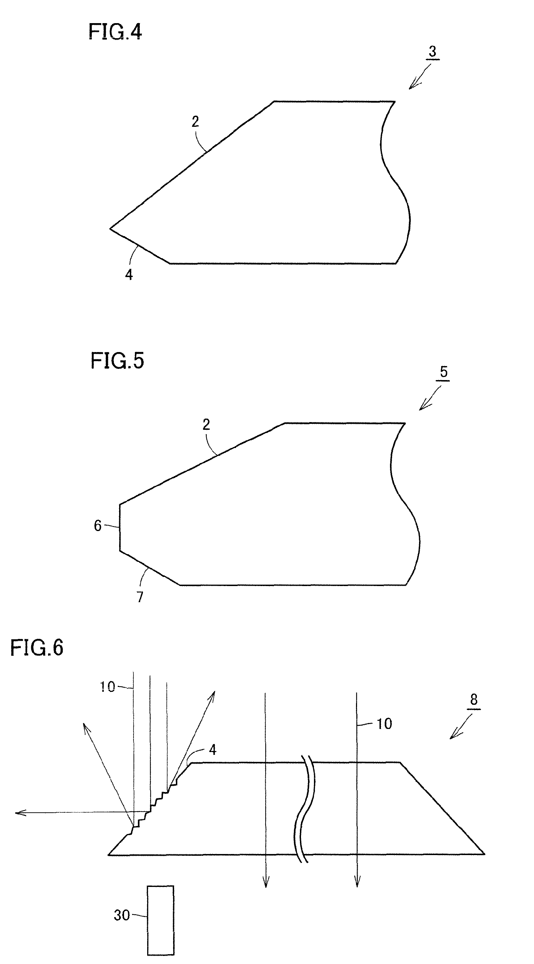

Referring to Figs. 4 and 5, modifications of the example of the substrate in the present invention are described. Although total reflection surface 2 may be formed almost entirely on the end surface of the peripheral portion of substrate 1 as shown in Fig. 1, total reflection surface 2 and a conventional and usual bevel cut surface 4 may both be present in the detection region, as a substrate 3 shown in Fig. 4, for example. That is, on the side (upper side in Fig. 4) on which light 10 is incident, total reflection surface 2 may be formed such that an angle formed between total reflection surface 2 and main surfaces (horizontal direction in Fig. 4) of substrate 3 satisfies a condition for totally reflecting light 10, and on the opposite side (lower side in Fig. 4) to the side on which light 10 is incident, usual bevel cut surface 4 for suppressing chipping and cleavage in substrate 3 may be formed, for example. Bevel cut surface 4 is formed to be inclined in the opposite direction to total reflection surface 2, such that substrate 3 decreases in width as bevel cut surface 4 approaches the opposite main surface (rear surface) to the main surface on which total reflection surface 2 of substrate 3 is formed, in order to form an acute angle at a corner of a connection portion to total reflection surface 4, as shown in Fig. 4.

Alternatively, as a substrate 5 shown in Fig. 5, for example, total reflection surface 2 may be formed to have an angle satisfying a condition similar to that of total reflection surface 2 of substrate 5 described above, and on the opposite side (lower side in Fig. 5) to the side on which light 10 is incident, an end surface 6 substantially perpendicular to the main surfaces (horizontal direction in Fig. 5) of substrate 5 and a usual bevel cut surface 7 may be formed. In short, from another perspective, at the peripheral end of substrate 5, total reflection surface 2 and bevel cut surface 7 may be arranged with end surface 6 substantially perpendicular to the main surfaces interposed therebetween.

Alternatively, although not shown, in the detection region of each substrate in Figs. 4 and 5 on the lower side of total reflection surface 2 (opposite side to the side on which light 10 is incident), a round (curved surface portion) continuous with total reflection surface 2 may be formed at the end portion of the substrate in Fig. 15 (left side in Fig. 15) instead of bevel cut surfaces 4, 7, and end surface 6. In this manner, the lower side of total reflection surface 2 of each substrate may be formed in any shape for suppressing cleavage and chipping in the substrate due to stress.

The step of forming total reflection surface 2 of each substrate according to the first embodiment of the present invention described above may include a step of machine-processing at least a portion of the end portion, or a step of laser-processing at least a portion of the end portion, for example. For example, total reflection surface 2 may be formed by removing a prescribed region at the end portion of the main surfaces of substrate 1 with a grindstone for grinding to form an angle satisfying a condition for totally reflecting light 10 emitted in a direction substantially perpendicular to the main surfaces. Alternatively, total reflection surface 2 may be formed by similarly removing the end portion of substrate 1 with a laser.

It is preferable to perform a process of reducing the surface roughness of total reflection surface 2 to a degree that can cause total reflection of emitted light 10. Specifically, it is preferable to perform a process such that the surface roughness becomes not more than 0.5 nm in terms of Ra, and more preferably not more than 0.1 nm in terms of Ra. With such surface roughness, emitted light 10 can be totally reflected readily. For such process, when total reflection surface 2 is formed by machining process for example, it is preferable that the grindstone used in finish processing has a grain size of not more than 100 nm. When total reflection surface 2 is formed with a laser, it is preferable to emit a UV laser having a wavelength of 266 nm.

### (Second Embodiment)

A substrate 8 shown in Fig. 6 according to a second embodiment of the present invention is basically formed in a manner similar to substrate 1 shown in Fig. 1 according to the first embodiment of the present invention. However, substrate 8 shown in Fig. 6 includes a diffuse reflection surface 9 for diffusely reflecting light 10 incident on the detection region, instead of total reflection surface 2 shown in Fig. 1 and the like. Substrate 8 is different from substrate 1 in this respect.

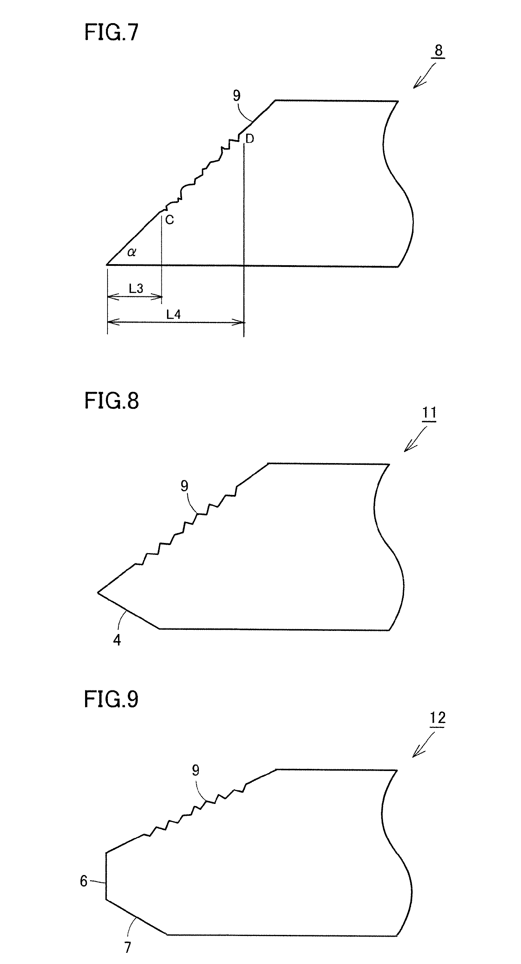

If transmission of light 10 emitted from a region facing one main surface (upper side in Fig. 6) of substrate 8 to the other main surface (lower side in Fig. 6) opposite to the one main surface of Fig. 8 can be suppressed, photoelectric sensor 30 arranged below substrate 8 can recognize that light 10 has been cut off by substrate 8, thereby detecting the presence of substrate 8. In order to suppress transmission of light 10 through substrate 8, incident light 10 may be totally reflected as in substrate 1 shown in Fig. 1. Alternatively, light 10 may be diffusely reflected from diffuse reflection surface 9 as in substrate 8 shown in Fig. 6, to produce a similar effect to that of total reflection.

Fig. 7 is a cross-sectional view showing enlarged diffuse reflection surface 9 on the left side of substrate 8 in Fig. 6. The right region of substrate 8 in Fig. 6 is not illustrated in Fig. 7. Thus, a wavy line is used on the right side in Fig. 7 to suggest that substrate 8 extends to the right.

Diffuse reflection surface 9 shown in Fig. 7 has been processed to have increased surface roughness as compared to total reflection surface 2 shown in Fig. 2. That is, as with the case shown in Fig. 2, diffuse reflection surface 9 of substrate 8 forms angle α with the main surfaces (surfaces extending in the horizontal direction in Fig. 7) of substrate 8, as shown in Fig. 7. Increasing the surface roughness means performing a process of roughening a surface (forming projections and recesses) to have surface roughness that can cause diffuse reflection of light 10 incident on the surface, and more specifically means performing a process such that the surface roughness of the surface becomes not less than 0.1 µm in terms of Ra.

The detection region, which has been processed to have increased surface roughness of its surface in order to function as diffuse reflection surface 9, is preferably formed in a region within a distance (from a left end toward the right in Fig. 7) of not less than 0.1 mm and not more than 5 mm from a peripheral end (left end in Fig. 7) of substrate 8 in the main surface direction, as shown in Fig. 7. That is, if diffuse reflection surface 9 is formed from a point C to a point D in Fig. 7, a distance L3 from the peripheral end of substrate 8 to point C in the main surface direction is preferably not less than 0.1 mm, and a distance L4 from the peripheral end of substrate 8 to point D in the main surface direction is preferably not more than 5 mm.

Diffuse reflection surface 9 should only be formed in at least a portion of an end portion of the main surface of substrate 8. That is, diffuse reflection surface 9 may be formed entirely in the region within a distance of not less than 0.1 mm and not more than 5 mm from an end surface of the main surface of substrate 8, all the way around the peripheral portion of the main surface of substrate 8, or may be formed only in a portion in a circumferential direction of the peripheral portion.

Fig. 7 shows one example where diffuse reflection surface 9 is formed by increasing the surface roughness of total reflection surface 2. Alternatively, although not shown, diffuse reflection surface 9 having high surface roughness may be formed at the end portion of the main surface of substrate 8 without forming a total reflection surface in advance (i.e., without forming an inclined portion or the like at the end portion of substrate 8). In addition, when a surface intersecting with the one main surface (upper main surface in Figs. 6, 7) of substrate 8 and the other main surface (lower main surface in Figs. 6, 7) is formed in order to form diffuse reflection surface 9, an angle formed between the intersecting surface and the main surfaces of substrate 8 need not be an angle satisfying a condition for total reflection of light 10, such as angle α shown in Fig. 7.

In the substrate according to the second embodiment of the present invention, diffuse reflection surface 9 and conventional and usual bevel cut surface 4 may both be present, as substrate 11 shown in Fig. 8, in the same manner as substrate 3 shown in Fig. 4 described above, for example. Alternatively, diffuse reflection surface 9, end surface 6 and bevel cut surface 7 may all be present, as substrate 12 shown in Fig. 9, for example, in the same manner as substrate 5 shown in Fig. 5 described above. Additionally, the lower side of diffuse reflection surface 9 of the substrate may be formed in any shape for suppressing cleavage and chipping in the substrate due to stress.

Next, a method of manufacturing the substrate according to the second embodiment of the present invention is described. In the method of manufacturing substrate 8 according to the second embodiment of the present invention, as shown in Fig. 3 described above, first at the substrate preparation step (S10), a transparent substrate to be used as a substrate of a semiconductor device is prepared. Next, at the processing step (S20), a process of making a light transmittance in a region in at least a portion of the end portion of the substrate lower than a light transmittance in a central portion of the main surface of the substrate is performed. In the second embodiment of the present invention, as substrate 8 shown in Fig. 6, for example, the processing step (S20) includes a step of forming diffuse reflection surface 9 for diffusely reflecting light incident on at least a portion of the end portion of the main surface of substrate 8.

As shown in Fig. 6, light 10 emitted to a region other than diffuse reflection surface 9 of substrate 8 is mostly transmitted through substrate 8 because substrate 8 is transparent. On the other hand, light 10 emitted to diffuse reflection surface 9 arranged in the detection region is diffusely reflected off diffuse reflection surface 9, so that light 10 hardly reaches photoelectric sensor 30 arranged below substrate 8 in Fig. 6. Therefore, photoelectric sensor 30 can recognize that light 10 has been cut off owing to the presence of substrate 8, thereby detecting the presence of substrate 8.

Here, as substrate 8 shown in Fig. 7, for example, in order to form diffuse reflection surface 9, a surface intersecting with the one main surface (upper main surface in Fig. 7) of substrate 8 and the other main surface (lower main surface in Fig. 7) may be formed first, and a process of increasing surface roughness of the formed surface may be performed. An angle formed between the intersecting surface and the main surfaces of substrate 8 may be angle α (see Fig. 1) satisfying a condition for total reflection of light 10 emitted in a direction perpendicular to the main surfaces, for example, or may be another arbitrary angle. Alternatively, diffuse reflection surface 9 having high surface roughness may be formed at the end portion of the main surface of substrate 8 without forming the intersecting surface. In either case, a region having high surface roughness for functioning as diffuse reflection surface 9 is preferably formed in a region of not less than 0.1 mm and not more than 5 mm from the end surface of the main surface of substrate 8.

The step of forming diffuse reflection surface 9 of the substrate according to the second embodiment of the present invention described above may include a step of machine-processing at least a portion of the end portion, or a step of laser-processing at least a portion of the end portion, for example, as with the step of forming total reflection surface 2 of the substrate according to the first embodiment of the present invention. If the machine processing step is used, for example, a process of forming a shape (end surface shape inclined with respect to the main surfaces of substrate 8) for forming diffuse reflection surface 9 as shown in substrate 8 is performed by using a grind stone, and a process of increasing the surface roughness is performed. If the process of laser-processing at least a portion of the end surface is used, a process of increasing the surface roughness by irradiating a prescribed region with a laser is performed. Specifically, a UV laser having a wavelength of 266 nm is preferably emitted.

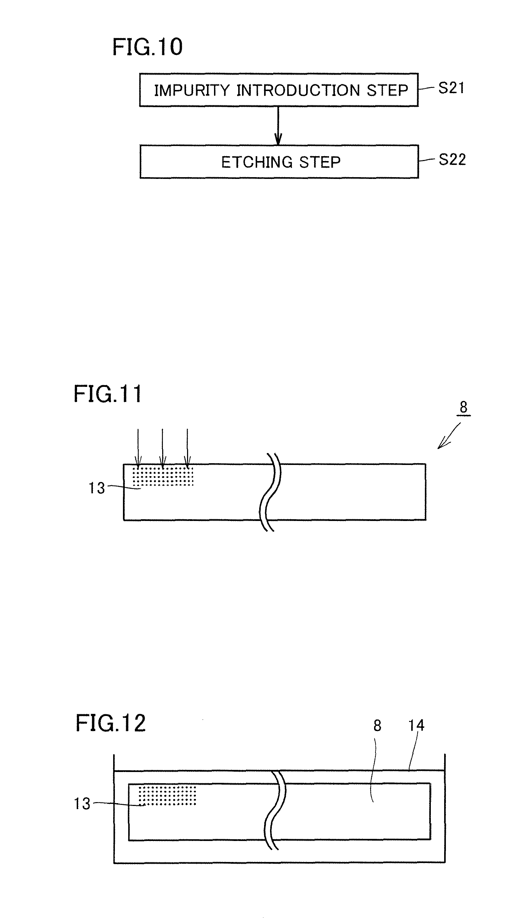

Alternatively, diffuse reflection surface 9 may be formed with a method described below, for example. As shown in Fig. 10, in this method, first as an impurity introduction step (S21), a step of introducing an impurity into a region of the substrate where the diffuse reflection surface is to be formed, i.e., a region in at least a portion of the end portion of the substrate, is performed.

As shown in Fig. 11, ions are implanted from the main surface into a region of substrate 8 where the diffuse reflection surface is to be formed, i.e., a region of not less than 0.1 mm and not more than 5 mm from the end portion (left end of substrate 8 in Fig. 11, for example) of the main surface of substrate 8, within substrate 8, to form a crystal defect 13 in substrate 8. A substance to be used for the ion implantation is preferably B (boron), N (nitrogen), Al (aluminum), or P (phosphorous), for example. Density (concentration) of an introduced impurity for the ion implantation is preferably not less than 1.0E17cm⁻³ and not more than 1.0E21cm⁻³, and more preferably not less than 1.0E19cm⁻³ and not more than 1.0E20cm⁻³. With density (concentration) in this range, the effect of diffuse reflection of light 10 incident on the region can be made greater.

Thereafter, as shown in Fig. 10, an etching step (S22) is performed. Specifically, this is a step of performing a wet etching process on a surface layer of the substrate where the ions were implanted in the above impurity introduction step (S21).

As shown in Fig. 12, substrate 8 in which defect 13 was formed by the ion implantation, for example, is immersed in a KOH solution 14. KOH is potassium hydroxide, which is a strongly alkaline substance having a strong etching property. Consequently, an etching rate of the main surface of substrate 8 partly varies (is not uniform) in the region of substrate 8 where defect 13 was formed due to the presence of defect 13, resulting in formation of projections and recesses in the etched surface. This increases surface roughness of the surface of the region where the defect was formed. A region of substrate 8 without defect 13 is not affected by the defect as described above, and is thus etched uniformly. Accordingly, an etched amount of the main surface is substantially uniform in this region, without great variation in surface roughness of the main surface.

With the procedure described above, surface roughness can be increased only in the region where crystal defect 13 was generated by ion implantation in the main surface of substrate 8. As such, the main surface of the region where the ions were implanted can be utilized as a diffuse reflection surface.

Instead of the ion implantation method described above, a thermal diffusion method may be used as an impurity introduction method, for example. In this case, as shown in Fig. 13, the impurity introduction step (S21) is performed first as with the case where the ion implantation method is used as shown in Fig. 10. Then, as shown in Fig. 13, a heat treatment step (S23) is performed instead of the etching step (S22) in the ion implantation method shown in Fig. 10. As a result, a defect is formed in a region where the impurity was introduced due to the presence of the introduced impurity, resulting in formation of projections and recesses in the region where the impurity was introduced.

In the impurity introduction step described above, a method other than the ion implantation method shown in Fig 10 may be used. Specifically, an object containing an impurity and a substrate are heated with the object contacting a region of the substrate where the impurity is to be introduced, for example. As a result, the impurity diffuses from the object into the substrate through solid diffusion.

Alternatively, a mask layer is formed to expose only a region of a substrate where an impurity is to be introduced, and the substrate having the mask layer is heated in a heat treatment furnace. During the heating, a gas containing the impurity to be introduced is used as an atmosphere gas in the heat treatment furnace. As a result, the impurity can be introduced into a prescribed region (region without the mask layer) of the substrate by the heat treatment.

After introducing the impurity with the above method (thermal diffusion method), the heat treatment step (S23) is performed. As a result, projections and recesses can be increased in the region where the impurity was introduced in the main surface of the substrate, thereby forming a diffuse reflection surface as with the case where the ion implantation method is used.

The second embodiment of the present invention is different from the first embodiment of the present invention only in the respects described above. That is, the second embodiment of the present invention is identical to the first embodiment of the present invention in all respects such as structure, condition, procedure and effect not mentioned above.

### (Third Embodiment)

A substrate 15 shown in Fig. 14 includes a thin film 16 in a region of not less than 0.1 mm and not more than 5 mm from an end surface of one main surface (upper main surface in Fig. 14) of substrate 15, for example, which is used as a detection region Thin film 16 diffusely reflects light 10 incident on the main surface of substrate 15 from above substrate 15 in a direction substantially perpendicular to the main surfaces of substrate 15. It is preferable to use a metal thin film that can cause reflection of visible light (red light), infrared light and the like at a high ratio, such as Cr (chromium), W (tungsten), or Al (aluminum), as a material for thin film 16.

Accordingly, light incident on the detection region can be diffusely reflected by thin film 16 in substrate 15 according to a third embodiment of the present invention, as with substrate 8 according to the second embodiment of the present invention described above, for example. Accordingly, an amount of light 10 incident on photoelectric sensor 30 arranged below substrate 15 (see Fig. 14) is reduced. Here, photoelectric sensor 30 can recognize that light 10 has been cut off, thereby detecting the presence of substrate 15.

A method of manufacturing the substrate according to the third embodiment of the present invention is identical to the method of manufacturing the substrate according to the first embodiment of the present invention shown in Fig. 3 described above. However, as the process of making the light transmittance in the region in at least a portion of the end portion of the substrate lower than the light transmittance in the central portion of the main surface of the substrate in the processing step (S20) in Fig. 3, thin film 16 is deposited on the one main surface of substrate 15 as shown in Fig. 14. Since thin film 16 is to be used as a diffuse reflection surface, thin film 16 is preferably deposited in a region within a distance of not less than 0.1 mm and not more than 5 mm from an end surface of the main surface of substrate 15 in the main surface direction, as with substrate 8 shown in Fig. 6, for example. As described above, it is preferable to use a metal thin film that can cause reflection of visible light (red light), infrared light and the like at a high ratio, such as Cr, W, or Al, as a material for thin film 16. A thickness of thin film 16 is preferably set to not less than 0.05 µm and not more than 1.0 µm, and more preferably not less than 0.1 µm and not more than 0.5 µm. Vapor deposition, CVD, sputtering or the like is preferably used as a method of forming thin film 16.

In the third embodiment of the present invention, although not shown, thin film 16 used as a diffuse reflection surface and conventional and usual bevel cut surface 4 may both be present, as with substrate 11 shown in Fig. 8, for example. Alternatively, thin film 16 used as a diffuse reflection surface, end surface 6 and bevel cut surface 7 may all be present, as with substrate 12 shown in Fig. 9, for example. Additionally, the lower side of thin film 16 used as a diffuse reflection surface of the substrate may be formed in any shape for suppressing cleavage and chipping in the substrate due to stress.

Although thin film 16 described above is formed as a diffuse reflection surface, thin film 16 may be formed as a total reflection surface by controlling a surface condition and the like of thin film 16.

The third embodiment of the present invention is different from the second embodiment of the present invention only in respects described above. That is, the third embodiment of the present invention is identical to the second embodiment of the present invention in all respects such as structure, condition, procedure and effect not mentioned above.

It should be understood that the embodiments disclosed herein are illustrative and non-restrictive in every respect. The scope of the present invention is defined by the terms of the claims, rather than the description above, and is intended to include any modifications within the scope and meaning equivalent to the terms of the claims.

### INDUSTRIAL APPLICABILITY

The present invention particularly excels as a technique that allows a sensor to recognize the presence of a transparent substrate during processing such as semiconductor device manufacture using the transparent substrate.

### DESCRIPTION OF THE REFERENCE SIGNS

1, 3, 5, 8, 11, 12, 15, 20 substrate; 2 total reflection surface; 4, 7 bevel cut surface; 6 end surface; 9 diffuse reflection surface; 10 light; 13 defect; 14 KOH solution; 16 thin film; 30 photoelectric sensor.

## Claims

1. A transparent substrate (1, 3, 5, 8, 11, 12, 15, 20), comprising a detection region (2, 9, 13) formed in at least a portion of an end portion of said substrate (1, 3, 5, 8, 11, 12, 15, 20) and having a transmittance of light lower than a transmittance of said light in a central portion of said substrate (1, 3, 5, 8, 11, 12, 15, 20).

2. The substrate according to claim 1, wherein
said detection region (2, 9, 13) includes a total reflection surface (2) for totally reflecting said light incident on said detection region (2, 9, 13).

3. The substrate according to claim 1, wherein
said detection region (2, 9, 13) includes a diffuse reflection surface (9) for diffusely reflecting said light incident on said detection region (2, 9, 13).

4. The substrate according to claim 1, wherein
said substrate (1, 3, 5, 8, 11, 12, 15, 20) includes at least one selected from the group consisting of SiC, GaN, sapphire, AlN, and diamond.

5. A method of manufacturing a substrate, comprising the steps of:
preparing a transparent substrate (1, 3, 5, 8, 11, 12, 15, 20) (S10); and
performing a process of making a transmittance of light in at least a portion of an end portion of said substrate (1, 3, 5, 8, 11, 12, 15, 20) lower than a transmittance of said light in a central portion of said substrate (S20).

6. The method of manufacturing a substrate according to claim 5, wherein
said step of performing said process (S20) includes the step of forming a total reflection surface (2) for totally reflecting said light incident on at least a portion of said end portion.

7. The method of manufacturing a substrate according to claim 6, wherein
said step of forming said total reflection surface (2) includes the step of machine-processing at least a portion of said end portion.

8. The method of manufacturing a substrate according to claim 6, wherein
said step of forming said total reflection surface (2) includes the step of laser-processing at least a portion of said end portion.

9. The method of manufacturing a substrate according to claim 5, wherein
said step of performing said process (S20) includes the step of forming a diffuse reflection surface (9) for diffusely reflecting light incident on at least a portion of said end portion.

10. The method of manufacturing a substrate according to claim 9, wherein
said step of forming said diffuse reflection surface (9) includes the step of machine-processing at least a portion of said end portion.

11. The method of manufacturing a substrate according to claim 9, wherein
said step of forming said diffuse reflection surface (9) includes the step of laser-processing at least a portion of said end portion.

12. The method of manufacturing a substrate according to claim 9, wherein
said step of forming said diffuse reflection surface (9) includes the step of introducing an impurity into at least a portion of said end portion (S21), and the step of increasing surface roughness of a surface of a region where said impurity was introduced (S22, S23).

13. The method of manufacturing a substrate according to claim 12, wherein
said step of increasing said surface roughness (S22, S23) includes the step of etching a surface layer of said region (S22) or the step of subjecting said surface layer of said region to heat treatment.

14. The method of manufacturing a substrate according to claim 9, wherein
said step of forming said diffuse reflection surface (9) includes the step of depositing a thin film (16) on at least a portion of said end portion.
